# EUROPEAN PATENT APPLICATION

(11) **EP 1 961 715 A1**
(43) Date of publication of application: **27.08.2008**
(21) Application number: 06832550.5
(22) Date of filing: 13.11.2006
(51) Int. Cl.: C04B 35/00, C23C 14/32

(54) **SINTERED BODY FOR VACUUM VAPOR DEPOSITION**

(30) Priority: 13.12.2005 JP 2005358802
(71) Applicant: Idemitsu Kosan Co., Ltd., Chiyoda-ku Tokyo 100-8321 (JP)
(72) Inventor: TOMAI, Shigekazu, Sodegaura-shi, Chiba 2990293 (JP); INOUE, Kazuyoshi, Sodegaura-shi, Chiba 2990293 (JP); FUKUDA, Masahiko, Sodegaura-shi, Chiba 2990293 (JP)
(74) Representative: Gille Hrabal Struck Neidlein Prop Roos
(86) International application number: PCT/JP2006/322538
(87) International publication number: WO 2007/069415

(57) **Abstract**

A sintered body for vacuum vapor deposition, the sintered body being a sintered body of an oxide containing at least one cation element; the cation element having an electronegativity of 1.5 or more; and the sintered body having a surface roughness of 3 µm or less and a bulk resistance of less than 1 x 10⁻¹ Ω·cm.

## Description

### TECHNICAL FIELD

The invention relates to a sintered body for vacuum vapor deposition. More specifically, the invention relates to a transparent conductive oxide material used for vacuum vapor deposition such as ion plating.

### BACKGROUND

Due to remarkable development of displays in recent years, liquid crystal displays (LCD), electroluminescence (EL) displays, field emission displays (FED), or other displays are installed in personal computers, TVs, cellular phones or other devices.

A mainstream material for such a transparent electrode used in these displays is indium tin oxide (hereinafter occasionally abbreviated as "ITO") prepared by the sputtering method, the ion plating method, or the vapor deposition method, as disclosed in Non-Patent Document 1.

ITO is composed of a specific amount of indium oxide and tin oxide, and has characteristics that it possesses excellent transparency and conductivity, can be etched with a strong acid, and exhibits improved adhesiveness to a substrate.

As disclosed in Patent Documents 1 through 5, a target composed of a specific amount of indium oxide, tin oxide and zinc oxide, a transparent electrode formed by using such a target (hereinafter occasionally referred to as "IZO") is known. IZO is widely used since it can be etched with a weak acid and is excellent in sintering properties and transparency.

As mentioned above, ITO or IZO exhibits excellent performance as a material for a transparent conductive oxide. Various methods are used for producing such a transparent electrode including sputtering, ion plating and the sol gel method. Of these methods, sputtering has been used most commonly in view of productivity, uniformity, thin film performance, yield, and other factors.

Ion plating is a method which is the second most common to sputtering. Ion plating is a vacuum vapor deposition method in which a vaporized product or a reactive gas (e.g. oxygen) is activated by various methods with the aim of improving reactivity and producing a low-resistance film at a low substrate temperature. Specific examples include the activated reactive evaporation method using a thermionic emitter or an RF discharge, the high density plasma assisted vapor deposition method using a plasma gun, and the PLD (pulse laser deposition) method in which a deposited product is irradiated with a condensed excimer laser beam.
Patent Document 1: JP-A-03-50148
Patent Document 2: JP-A-05-155651
Patent Document 3: JP-A-05-70943
Patent Document 4: JP-A-06-234565
Patent Document 5: JP-A1-2001-038599
Non-Patent Document 1: "Technology of Transparent Conductive Film" edited by The 166th Committee of Transparent Oxide and Photoelectron Material, Japan Society for Promotion of Science, Ohmsha, Ltd. (1999)

However, the above-mentioned ion plating has a problem in which a large number of micron-sized particles called droplets adhere to a substrate when vaporizing a deposited product by heating with an electron beam. Since droplets adhere to a substrate in a projected state with a size of several microns or larger, it can cause a display electrode to be fatally disadvantageous.
An object of the invention is to provide a sintered body for vaccum vapor deposition which enables vapor vaccum deposition to be performed stably while suppressing generation of droplets when forming a transparent conductive oxide in a film by the vacuum vapor deposition method.

### SUMMARY OF THE INVENTION

As a result of extensive studies, the inventors have found that generation of droplets can be suppressed by the use of a sintered body obtained by using an oxide having an electronegativity above a certain level, and having a surface roughness and a bulk resistance ajusted to specific values.
The invention provides the following sintered body for vacuum vapor deposition:
1. A sintered body for vacuum vapor deposition,
   the sintered body being a sintered body of an oxide containing at least one cation element;
   the cation element having an electronegativity of 1.5 or more; and
   the sintered body having a surface roughness of 3 µm or less and a bulk resistance of less than 1 x 10⁻¹ Ω·cm.
2. The sintered body for vacuum vapor deposition according to 1 which is obtained by sintering raw material powder having an average particle size of 0.1 to 3.0 µm.
3. The sintered body for vacuum vapor deposition according to 1 or 2 containing indium oxide as a main component and further containing tin oxide and/or zinc oxide.
4. The sintered body for vacuum vapor deposition according to any one of 1 to 3 wherein the sintered body has a density of 4.0 to 6.0 g/cm³.
5. The sintered body for vacuum vapor deposition according to any one of 1 to 4 wherein the atomic ratio of indium atom to the total of indium atom and zinc atom [In/(In + Zn)] is 0.6 to 0.99.
6. The sintered body for vaccum vapor deposition according to any one of 1 to 4 wherein the atomic ratio of indium atom to the total of indium atom and tin atom [In/(In + Sn)] is 0.6 to 0.99.
7. The sintered body for vaccum vapor deposition according to any one of 1 to 6 which contains a hexagonal layered compound shown by In₂O₃(ZnO)ₘ (wherein m is an integer of 2 to 20), the hexagonal layered compound having a crystal grain size of 3 µm or less.

The invention can provide a sintered body for vacuum vapor deposition which enables vapor vaccum deposition to be performed stably while suppressing generation of droplets when forming a transparent conductive oxide in a film by vacuum vapor deposition.

### BEST MODE FOR CARRYING OUT THE INVENTION

The sintered body for vaccum vapor deposition of the invention is a sintered body comprising an oxide containing at least one cation element, in which the cation element has an electronegativity of 1.5 or more and the sintered body has a surface roughness of 3 µm or less and a bulk resistance of less than 1 × 10⁻¹ Ω·cm.

The electronegativity of the cation element contained in the sintered body for vapor vaccum deposition of the invention is 1.5 or more. If the sintered body contains a cation element having an electronegativity of less than 1.5, droplets tend to generate easily during deposition. The electronegativity of the cation element is preferably 1.7 to 1.9. It is preferred that the electronegativity of the cation element constituting the oxide be close to 3.5, which is the electronegativity of oxygen. The reason therefor is considered to be as follows. Interaction between molecules or clusters of an oxide is small if boding is covalent rather than ionic, thereby suppressing generation of droplets.
The electronegativity is the value described on page 80 of Ceramic Chemistry (the second printing of the revised version, edited by The Ceramic Society of Japan).

Specific examples of the cation element having an electronagativity of 1.5 or more include indium, zinc and tin.

The surface roughness of the sintered body for vacuum vapor depostion of the invention is 3 µm or less. By rendering the surface roughness within this range, generation of droplets can be suppressed. The surface roughness is preferably 0 to 1 µm. Although a smaller surface roughness is preferable, the lower limit thereof is around 0.5 µm taking into consideration duration, efficiency or the like of polishing treatment.
The mechanism of droplet generation appears to be as follows. Projected portions on the surface of the sintered body are melted all at once when a material is heated, the melted projected portions become spherical by surface tension, and then adhere to a substrate, not as vapor but as splash.
In the specification, the "surface roughness" means a surface rougness value Ra measured by means of DEKTAK supplied by Sloan Technology Corp or other apparatuses, with the sweep length of a stylus being 5 mm.
Methods for obtaining a sintered body with a surface roughness of the above-mentioned value or less include a surface polishing treatment, mentioned later.

The sintered body for vacuum vapor deposition of the invention has a bulk resistance of less than 1 × 10⁻¹ Ω·cm, preferably 0 to 6 × 10⁻³ Ω·cm.
Due to this value of bulk resistance, a smooth temperature gradient is obtained inside the sintered body, preventing bumping caused by local heating.
Here, the bulk resistance is a value measured by the four probe method. Although a smaller bulk resistance is preferable, the lower limit thereof is about 2.0 x 10⁻⁴ Ω·cm.
The bulk resistance of the sintered body can be adjusted by controlling the purity or particle size of the raw material used.

It is preferred that the sintered body of the invention be a sintered body obtained by sintering raw material powder having an average particle size of 0.1 µm to 3.0 µm. If the average particle size is less than 0.1 µm, agglomeration tends to occur, resulting in difficulty in uniform mixing. If the average diameter exceeds 3.0 µm, the surface roughess exceeds 3.0 µm even though accurate polishing is conducted, and the projected portions are concentratively heated during vacuum vapor deposition. As a result, droplets may be generated easily. The average particle diameter of the raw material powder is particularly preferably 0.1 µm to 1.0 µm, more preferably 0.15 µm to 0.45 µm.

Preferable examples of the sintered body for vaccum vapor deposition of the invention include a sintered body containing indium oxide as a main component and containing tin oxide and/or zinc oxide as additive elements. Due to this composition, the sintered body has not only high electrical conductivity but also excellent thermal conductivity. As a result, during electron beam irradiation, there is a lower likelihood of occurrence of bumping or formation of particles which causes droplets to be generated.

If a sintered body of the invention contains indium oxide and zinc oxide, the ratio of indium atom to the total of indium atom and zinc atom [In/(In + Zn)] is preferably 0.6 to 0.99.
If a sintered body of the invention contains indium oxide and tin oxide, the ratio of indium atom to the total of indium atom and tin atom [In/(In + Sn)] is preferably 0.6 to 0.99.
The atomic ratio of indium atom, zinc atom and tin atom is a value obtained by measuring by means of an ICP emission spectrometer. The above-mentioned atomic ratios can be adjusted by controlling the amount ratio of the raw material oxides.

It is further preferred that the sintered body for vacuum vapor deposition of the invention contain a hexagonal layered compound shown by In₂O₃(ZnO)ₘ (wherein m is an integer of 2 to 20). The crystal grain diameter of this hexagonal layered compound is 3 µm or less. Due to the presence of such a hexagonal layered compound, droplet generation can be prevented most effieciently.
A hexagonal layered compound is formed by controlling the sintering time and the sintering temperature during the sintering step, or by subjecting the raw material powder to prefiring.

The crystal grain diameter of a hexagonal layered compound can be measured by means of an electron probe microanalyzer (hereinafter occasionally abbreviated as EPMA). Specifically, the crystal grain diameter is measured as follows. The target surface is polished smoothly. Thereafter, the target surface is enlarged 5,000 times by means of a microscope. In this enlarged state, a 30 µm x 30 µm square frame is set in an arbitral position, and the maximum diameter of the crystal particles of a hexagonal layered compound observed within this frame is measured by means of an EPMA. The maximum diameter is measured in at least three frames, the average value thereof is calculated. The so-obtained average value is the crystal grain diameter of a hexagonal layered compound.
The crystal grain diameter of this hexagonal layered compound can be easily identified by zinc mapping (concentration distribution) by means of an EPMA, allowing actual measurement of the crystal grain diameter.

The method for producing the sintered body for the vacuum vapor deposition of the invention is described below.
As the raw material of the sintered body, oxide powder containing a cation element having an electronegativity of 1.5 or more can be used. One kind of oxide powder may be used or two or more kinds of oxide powder may be used in a mixture.
It is preferred that the purity of the oxide containing a cation element having an electronegativity of 1.5 or more be 99% or more, more preferably 99.9% or more, and particularly preferably 99.99% or more. If the purity is less than 99%, problems may arise in which a dense sintered body can not be obtained by sintering or the bulk resistance is increased.

The oxide powder as the raw material is treated in the order of mixing, molding, sintering, and surface polishing, whereby a sintered body for vaccum vapor deposition is produced. The method will be described in detail below, in which indium oxide and zinc oxide are used as raw material oxides.
If the particle diameter of the raw material oxide powder exceeds 10 µm, it is preferable to adjust the average particle diameter so that it will be in the above-mentioned preferable range by using a ball mill, a roll mill, a pearl mill, a jet mill or the like.

### (1) Mixing step

It is preferred that mixing be conducted by putting indium oxide powder and zinc oxide powder in a mixer such as a ball mill, a jet mill or a pearl mill, followed by mixing. The mixing time is preferably 1 to 100 hours, more preferably 5 to 50 hours, and particularly preferably 10 to 50 hours. If the mixing time is shorter than 1 hour, mixing may not be sufficient. A mixing time exceeding 100 hours is economically disadvantageous. Although there are no particular restrictions on the mixing temperature, mixing is preferably conducted at room temperature.

The powder mixture after the mixing step may be subjected to prefiring in order to promote generation of a hexagonal layered compound.
Prefiring temeprature is preferably 800 to 1500°C, more preferably 900 to 1400°C, and particularly preferably 1000 to 1300°C. If prefiring temperature is lower than 800°C, a hexagonal layered compound may not be generated. If prefiring temperature exceeds 1500°C, evaporation of indium oxide or zinc oxide may occur.
Prefiring time is preferably 1 to 100 hours, more preferably 2 to 50 hours, and particularly preferably 3 to 30 hours. If prefiring time is shorter than 1 hour, a hexagonal layered compound may not be generated sufficiently. A prefiring time exceeding 100 hours is economically disadvantageous.

It is preferable to pulverize the prefired product in order to allow the particle size thereof to be 0.01 to 10 µm, which is a preferable range. Pulverizing can be performed by the same manner as the mixing as mentioned above. In order to promote generation of a hexagonal layered compound, it is preferable to repeat prefiring and pulverization.

The powder mixture or the prefired product of indium oxide and zinc oxide may be granulated to improve flowability or chargeability at the time of molding. Granulation is performed by a common method such as spray drying. When granulation is conducted by spray drying, an aqueous solution or an alcohol solution of the powder is used, and polyvinyl alcohol or the like is used as a binder to be mixed in the solution.
Although the granulation conditions may vary depending on the concentration of the solution and the amount of the binder to be added, it is preferable to adjust the conditions so that the average diameter of the granulated product becomes 1 to 100 µm, preferably 5 to 100 µm, and particularly preferably 10 to 100 µm. If the average particle diameter of the granulated product exceeds 100 µm, flowability or chargeability at the time of molding may be deteriorated, which means that the intended advantages of granulation cannot be obtained.

### (2) Molding step

The powder mixture of indium oxide and zinc oxide, the prefired product or the granulated product thereof is molded into a desired shape such as a tubular shape. Molding can be performed by die molding, cast molding or injection molding. Polyvinyl alcohol, methyl cellulose, polywax, oleic acid or the like may be used as a molding aid.
Molding pressure is preferably 10 kg/cm² to 100 t/cm², more preferably 20 kg/cm² to 1 t/cm². If the molding pressure is less than 10 kg/cm², the density of the sintered body obtained by sintering may not be increased, and the bulk resistance of the sintered body may not be less than 1 × 10⁻¹ Ω·cm.
The molding time is preferably 10 minutes to 10 hours. If the molding time is shorter than 10 minutes, the density of the sintered body obtained by sintering may not be increased, and the bulk resistance of the sintered body may not be less than 1 x 10⁻¹ Ω·cm, as in the case of the molding pressure.

### (3) Sintering step

The molded product is sintered preferably by normal-pressure firing. Other sintering methods include HIP (hot isostatic pressure) sintering and hot-press sintering. From an economical viewpoint, normal-pressure sintering is superior.
Sintering temperature is preferably 1200 to 1600°C, more preferably 1250 to 1550°C, further preferably 1300 to 1500°C. If sintering temperature is less than 1200°C, a hexagonal layered compound shown by In₂O₃(ZnO)ₘ (wherein m is an integer of 2 to 20) may not be generated. If sintering temperature exceeds 1600°C, indium oxide or zinc oxide may sublime to cause the composition to vary, the m value of the resulting hexagonal layered compound shown by In₂O₃(ZnO)ₘ may exceed 20, or the volume resistivity of the sintered body may be increased.
After sintering, if necessary, the above-obtained sintered body is subjected to a working step where the sintered body is cut into a shape suitable for a vapor deposition apparatus to be used.

If indium is contained as the main component, it is preferred that the density of the sintered body be 4.0 to 6.0 g/cm³. If the density is less than 4.0 g/cm³, thermal conductivity may deteriorate, and as a result, the sintered body may be locally heated during vacuum vapor deposition, causing bumping to occur. If the density exceeds 6.0 g/cm³, the sintered body may not be resistant to the thermal stress during heating, resulting in a higher likelihood of cracking of the sintered body. If indium is contained as the main component, it is preferred that the sintered body have a density of 4.2 to 5.2 g/cm³.

### (4) Surface polishing step

Both the dry polishing method and the wet polishing method may be used in the mechanical surface polishing treatment. In order to uniformly treat the entire surface of the sintered body while maintaining the precision of shape and size, the surface polishing is preferably performed by the following method.

As the dry surface polishing treatment, the dry barrel treatment or the dry blast treatment is preferable.
When the dry barrel treatment is used, known barrel polishing apparatuses including a rotary barrel polishing apparatus, a vibration barrel polishing apparatus and a centrifugal barrel polishing machine may be used.
When a rotary or centrifugal apparatus is used, it is preferred that the number of revolutions be 50 to 300 rpm. If a vibration apparatus is used, it is preferred that the amplitude of vibration be 0.3 to 10 mm.
As the medium to be used, a resin medium in which polishing powder is mixed is preferable. There are no particular restrictions on the polishing powder insofar as it has a higher degree of hardness than that of the sintered body to be polished. Ceramic powder such as Al₂O₃ and ZrO₃, diamond powder or the like are preferably used.
The treatment time varies depending on the volume or other factors of the sintered body. Normally, it is preferred that the treatment time be 60 seconds or more. For a satisfactory effect and efficiency, the treatment time is preferably 15 minutes or shorter.

When dry blast polishing is used, taking hardness of the sintered body or the like into consideration, it is important to select the material and the grain size of a projection material, the projection pressure or the like in order to prevent the projection material from being embedded into the surface of the sintered body.

As for the wet surface polishing treatment, wet barrel treatment is preferable. The barrel polishing apparatus, the polishing medium, treatment conditions or the like may be similar to those for the dry barrel treatment. After conducting the wet surface polishing treatment, it is preferred that the sintered body be immediately transferred to a liquid medium to prevent powder generated during the treatment from adhering to the surface of the sintered body.
Preferable embodiments include transferring the sintered body to water in an ultrasonic cleaning tank and transferring the sintered body to water in a cleaning tank for temporarily storing the sintered body until conducting ultrasonic cleaning.

Comparing the dry surface polishing treatment to the wet surface polishing treatment, the former is preferable since the risk of adhesion of powder generated during the treatment to the surface of the sintered body is low, there is no need to provide a cleaning step since polishing liquid or the like is not necessary, or for other reasons.

An example of the method for producing the oxide sintered body composed of indium oxide and zinc oxide is explained hereinabove. The oxide mixture to which the production method is applied is not limited to the mixture of indium oxide and zinc oxide. The method can be applied to other oxide mixtures, for example a mixture of indium oxide and tin oxide.

### EXAMPLES

### Example 1

### (1) Production of sintered body for vacuum vapor deposition

As the raw material, indium oxide having an average particle diameter of 1 µm (electronegativity of indium: 1.7) and zinc oxide having an average particle diameter of 1 µm (electronegativity of zinc: 1.6) were mixed such that the atomic ratio of indium [In/(In + Zn)] became 0.83. The resulting mixture was supplied to a wet ball mill, and mixed and pulverized for 72 hours, whereby raw material fine powder was obtained.
The average particle size of the raw materials was measured by means of an electron microscope.
The raw material fine powder was granulated, and the granulated product was then press-molded to have a diameter of 3 cm and a length of 10 cm. The molded product was put into a firing kiln, and firing was conducted under oxygen pressure at 1450°C for 36 hours, whereby an oxide sintered body composed of a transparent conductive material was obtained.
The resulting sintered body had a density of 4.8 g/cm³ and a bulk resistance of 0.91 x 10⁻² Ω·cm.
The density was measured by the Archimedes principle, and the bulk resistance was measured by the four probe method.

Then, the crystal state in the sintered body was observed by the X-ray diffraction method, using a sample collected from the sintered body. As a result, it was confirmed that the sample contained a hexagonal layered compound composed of indium oxide and zinc oxide, which is shown by In₂O₃(ZnO)₃.
Furthermore, the sintered body was buried in a resin, and the surface was ground using alumina particles with a particle diameter of 0.05 µm and observed using an EPMA ("JXA-8621MX" manufactured by JEOL Ltd.) to measure the maximum diameter of the crystal particles of the hexagonal layered compound observed in a 30 µm × 30 µm square frame on the surface of the sintered body enlarged to a magnification of 5,000 times. The average value of the maximum particle diameters measured in the same manner in three frames was calculated to confirm that the crystal grain diameter of the sintered body was 3.0 µm.

The resulting sintered body was cut to prepare a deposition rod having a diameter of about 2.5 cm and a length of about 8 cm. The entire surface of the rod was polished with a grinder with a small grain diameter (#1500). Thereafter, the surface roughness Ra was measured, and it was found that the surface roughness was 0.9 µm.
The surface roughness was measured by means of Dektak 3030 supplied by Sloan Technology Corp, with the sweep length of a stylus being 5 mm.

### (2) Film formation of transparent conductive oxide

The sintered body obtained in (1) above was installed in an ion plating apparatus. At room temperature, a transparent conductive oxide was formed in a film on a glass substrate.
After vacuuming to 5 x 10⁻⁴ Pa, argon was introduced into a heat cathode source to generate a discharge. An electron beam was withdrawn from this Al plasma, and the sintered body was irradiated with this electron beam.
At this time, the electric current was 20A. As a result, a transparent conductive glass in which a transparent conductive oxide film with a thickness of about 120 nm was formed on a glass substrate was obtained.

### (3) Evaluation of properties of transparent conductive oxide

To evaluate the conductivity of the transparent conductive oxide on the transparent conductive glass obtained in (2) above, the specific resistance was measured by the four probe method, and found to be 2.5 x 10⁻⁴ Ω·cm.
An X-ray diffraction analysis revealed that this transparent conductive oxide was amorphous. The film surface was found to be smooth since the P-V value (according to JIS B0601) was 5 nm.

### Example 2

### (1) Production of sintered body for vacuum vapor deposition

As the raw material, indium oxide having an average particle diameter of 2.8 µm and tin oxide having an average particle diameter of 1 µm (electronegativity of tin: 1.8) were mixed such that the atomic ratio of indium [In/(In + Sn)] became 0.90. The resulting mixture was supplied to a wet ball mill, and mixed and pulverized for 72 hours, whereby raw material fine powder was obtained.
The resulting raw material fine powder was granulated, and the granulated product was then press-molded to have a diameter of 3 cm and a length of 10 cm. The molded product was put in a firing kiln, and firing was conducted under oxygen pressure at 1450°C for 36 hours, whereby an oxide sintered body was obtained.
The resulting sintered body had a density of 5.0 g/cm³ and a bulk resistance of 0.55 x 10⁻² Ω·cm.

The resulting sintered body was cut and surface-polished in the same manner as in Example 1 to prepare a vapor deposition rod having a diameter of about 2.5 cm and a length of about 8 cm. The surface roughness was measured and found to be 2.4 µm.

### (2) Film formation of transparent conductive oxide

The vapor deposition rod obtained in (1) above was installed in an ion plating apparatus. At room temperature, a transparent conductive oxide was formed in a film on a glass substrate.
After vacuuming to 5 x 10⁻⁴ Pa, argon was introduced into a heat cathode source to generate a discharge. An electron beam was withdrawn from this Ar plasma, and the sintered body was irradiated with this electron beam. At this time, the electric current was 20A. As a result, a transparent conductive glass in which a transparent conductive oxide film with a thickness of about 120 nm was formed on a glass substrate was obtained.

### (3) Evaluation of properties of transparent conductive oxide

To evaluate the conductivity of the transparent conductive oxide on the transparent conductive glass obtained in (2) above, the specific resistance was measured by the four probe method, and found to be 4.5 x 10⁻⁴ Ω·cm.
An X-ray diffraction analysis revealed that this transparent conductive oxide was amorphous. The film surface was found to be smooth since the P-V value was 5 nm.

### Example 3

### (1) Production of sintered body for vacuum vapor deposition

As the raw material, indium oxide having an average particle diameter of 0.3 µm and tin oxide having an average particle diameter of 0.3 µm were mixed such that the atomic ratio of indium [In/(In + Sn)] became 0.50. The resulting mixture was supplied to a wet ball mill, and mixed and pulverized for 72 hours, whereby raw material fine powder was obtained.
The resulting raw material fine powder was granulated, and the granulated product was then press-molded to have a diameter of 3 cm and a length of 10 cm. The molded product was put in a firing kiln, and firing was conducted under oxygen pressure at 1450°C for 36 hours, whereby a sintered body was obtained.
The resulting sintered body had a density of 4.8 g/cm³ and a bulk resistance of 0.9 x 10⁻¹ Ω·cm.

The resulting sintered body was cut and surface-polished in the same manner as in Example 1 to prepare a vapor deposition rod having a diameter of about 2.5 cm and a length of about 8 cm. The surface roughness was measured and found to be 2.49 µm.

### (2) Film formation of transparent conductive oxide

The sintered body obtained in (1) above was installed in an ion plating apparatus. At room temperature, a transparent conductive oxide was formed in a film on a glass substrate.
After vacuuming to 5 × 10⁻⁴ Pa, argon was introduced into a heat cathode source to generate a discharge. An electron beam was withdrawn from this Ar plasma, and the sintered body was irradiated with this electron beam. At this time, the electric current was 16A. As a result, a transparent conductive glass in which a transparent conductive oxide film with a thickness of about 120 nm was formed on a glass substrate was obtained.

### (3) Evaluation of properties of transparent conductive oxide

To evaluate the conductivity of the transparent conductive oxide on the transparent conductive glass obtained in (2) above, the specific resistance was measured by the four probe method, and found to be 4.5 x 10⁻³ Ω·cm.
An X-ray diffraction analysis revealed that this transparent conductive oxide was amorphous. The film surface was found to be smooth since the P-V value was 5 nm.

### Example 4

### (1) Production of sintered body for vacuum vapor deposition

As the raw material, indium oxide having an average particle diameter of 0.1 µm and tin oxide having an average particle diameter of 0.1 µm were mixed such that the atomic ratio of indium [In/(In + Sn)] became 0.20. The resulting mixture was supplied to a wet ball mill, and mixed and pulverized for 72 hours, whereby raw material fine powder was obtained.
The raw material fine powder was granulated, and the granulated product was then press-molded to have a diameter of 3 cm and a length of 10 cm. The molded product was put into a firing kiln, and firing was conducted under oxygen pressure at 1450°C for 36 hours, whereby a sintered body composed of a transparent conductive material was obtained.
The resulting sintered body had a density of 5.0 g/cm³ and a bulk resistance of 0.9 x 10⁻¹ Ω·cm.

The resulting sintered body was cut and surface-polished in the same manner as in Example 1 to prepare a vapor deposition rod having a diameter of about 2.5 cm and a length of about 8 cm. The surface roughness was measured and found to be 2.9 µm.

### (2) Film formation of transparent conductive oxide

The sintered body obtained in (1) above was installed in an ion plating apparatus. At room temperature, a transparent conductive oxide was formed in a film on a glass substrate.
After vacuuming to 5 x 10⁻⁴ Pa, argon was introduced into a heat cathode source to generate a dicharge. An electron beam was withdrawn from this Ar plasma, and the sintered body was irradiated with this electron beam. At this time, the electric current was 6A. As a result, a transparent conductive glass in which a transparent conductive oxide film with a thickness of about 120 nm was formed on a glass substrate was obtained.

### (3) Evaluation of properties of transparent conductive oxide

To evaluate the conductivity of the transparent conductive oxide on the transparent conductive glass obtained in (2) above, the specific resistance was measured by the four probe method, and found to be 4.5 x 10⁻³ Ω·cm.
An X-ray diffraction analysis revealed that this transparent conductive oxide was amorphous. The film surface was found to be smooth since the P-V value was 5 nm.

### Comparative Example 1

### (1) Production of sintered body for vacuum vapor deposition

As the raw material, indium oxide having an average particle diameter of 1 µm and tin oxide having an average particle diameter of 1 µm were mixed such that the atomic ratio of indium [Tn/(In + Sn)] became 0.20. The resulting mixture was supplied to a wet ball mill, and mixed and pulverized for 72 hours, whereby raw material fine powder was obtained.
The raw material fine powder was granulated. The granulated product was then press-molded to have a diameter of 3 cm and a length of 10 cm. The molded product was put in a firing kiln, and firing was conducted under oxygen pressure at 1450°C for 36 hours, whereby a sintered body was obtained.
The resulting sintered body had a density of 4.0 g/cm³ and a bulk resistance of 0.9 x 10⁻¹ Ω·cm.
The resulting sintered body was cut to prepare a vapor deposition rod having a diameter of about 2.5 cm and a length of about 8 cm. Since surface polishing was not conducted, the surface roughness was found to be 5.5 µm.

### (2) Film formation of transparent conductive oxide

The sintered body obtained in (1) above was installed in an ion plating apparatus. At room temperature, a transparent conductive oxide was formed in a film on a glass substrate.
After vacuuming to 5 x 10⁻⁴ Pa, argon was introduced into a heat cathode source to generate a discharge. An electron beam was withdrawn from this Ar plasma, and the sintered body was irradiated with this electron beam.
At this time, the electric current was 6A. During the film formation, splashing of the depositon material was observed three times, and a transparent conductive glass in which a transparent conductive oxide film with a thickness of about 120 nm was formed on a glass substrate was finally obtained.

### (3) Evaluation of properties of the transparent conductive oxide

To evaluate the conductivity of the transparent conductive oxide on the transparent conductive glass obtained in (2) above, the specific resistance was measured by the four probe method, and found to be 4.5 x 10⁻³ Ω·cm.
An X-ray diffraction analysis revealed that this transparent conductive oxide was amorphous. The film surface was found to be rough since the P-V value was 15 nm. It is supposed that splashing occurred due to the large surface roughness value of 5.5 µm of the sintered body, which caused the roughness of the film to increase.

### Comparative Example 2

### (1) Production of sintered body for vacuum vapor deposition

As the raw material, indium oxide having an average particle diameter of 1 µm and magnesium oxide having an average particle diameter of 1 µm (electronegativity of Mg: 1.2) were mixed such that the atomic ratio of indium [In/(In + Mg)] became 0.90. The resulting mixture was supplied to a wet ball mill, and mixed and pulverized for 72 hours, whereby raw material fine powder was obtained.
The resulting raw material fine powder was granulated, and the granulated product was then press-molded to have a diameter of 3 cm and a length of 10 cm. The molded product was put in a firing kiln, and firing was conducted under oxygen pressure at 1450°C for 36 hours, whereby an oxide sintered body was obtained.
The resulting sintered body had a density of 4.4 g/cm³ and a bulk resistance of 0.75 x 10⁻³Ω·cm.

The resulting sintered body was cut and surface-polished in the same manner as in Example 1 to prepare a vapor deposition rod having a diameter of about 2.5 cm and a length of about 8 cm. The surface roughness was measured and found to be 2.8 µm.

### (2) Film formation of transparent conductive oxide

The sintered body obtained in (1) above was installed in an ion plating apparatus. At room temperature, a transparent conductive oxide was formed in a film on a glass substrate.
After vacuuming to 5 x 10⁻⁴ Pa, argon was introduced into a heat cathode source to generate a discharge. An electron beam was withdrawn from this Ar plasma, and the sintered body was irradiated with this electron beam. At this time, the electric current was 20A. During the film formation, splashing of the depositon material was observed twice, and a transparent conductive glass in which a transparent conductive oxide film with a thickness of about 120 nm was formed on a glass substrate was finally obtained.

### (3) Evaluation of properties of the transparent conductive oxide

To evaluate the conductivity of the transparent conductive oxide on the transparent conductive glass obtained in (2) above, the specific resistance was measured by the four probe method, and found to be 7.5 x 10⁻⁴ Ω·cm.

An X-ray diffraction analysis revealed that this transparent conductive oxide was amorphous. The film surface was found to be rough since the P-V value was as large as 53 nm in contrast to those in Examples 1 to 3.
The reason therefor is considered to be as follows. Since the electronegativity of magnesium used as the raw material was as small as 1.2, polarization was increased when the oxide was formed. When such a material was subjected to vapor vaccum deposition, interaction between the deposited products was increased, causing them to grow as droplets before adhering to the substrate. As a result, the roughess of the substrate surface was increased.

### INDUSTRIAL APPLICABILITY

The sintered body for vacuum vapor deposition of the invention can be used as a transparent electrode material for liquid crystal displays, electroluminescence devices, or the like.

## Claims

1. A sintered body for vacuum vapor deposition,
the sintered body being a sintered body of an oxide containing at least one cation element;
the cation element having an electronegativity of 1.5 or more; and
the sintered body having a surface roughness of 3 µm or less and a bulk resistance of less than 1 x 10⁻¹ Ω·cm.

2. The sintered body for vacuum vapor deposition according to claim 1 which is obtained by sintering raw material powder having an average particle size of 0.1 to 3.0 µm.

3. The sintered body for vacuum vapor deposition according to claim 1 or 2 containing indium oxide as a main component and further containing tin oxide and/or zinc oxide.

4. The sintered body for vacuum vapor deposition according to any one of claims 1 to 3 wherein the sintered body has a density of 4.0 to 6.0 g/cm³.

5. The sintered body for vacuum vapor deposition according to any one of claims 1 to 4 wherein the atomic ratio of indium atom to the total of indium atom and zinc atom [In/(In + Zn)] is 0.6 to 0.99.

6. The sintered body for vaccum vapor deposition according to any one of claims 1 to 4 wherein the atomic ratio of indium atom to the total of indium atom and tin atom [In/(In + Sn)] is 0.6 to 0.99.

7. The sintered body for vaccum vapor deposition according to any one of claims 1 to 6 which contains a hexagonal layered compound shown by In₂O₃(ZnO)ₘ (wherein m is an integer of 2 to 20), the hexagonal layered compound having a crystal grain size of 3 µm or less.
